# DEMANDE DE BREVET EUROPEEN

(11) **EP 1 589 587 A1**
(43) Date de publication de la demande: **26.10.2005**
(21) Numéro de dépôt: 05290860.5
(22) Date de dépôt: 19.04.2005
(51) Int. Cl.: H01L 31/0203, H01L 31/0232

(54) **Boitier semi-conducteur optique à moyen compressible de réglage**

(30) Priorité: 20.04.2004 FR 0404133
(71) Demandeur: STMicroelectronics SA, 92120 Montrouge (FR)
(72) Inventeur: Vittu, Julien, 38340 Vorepe (FR)
(74) Mandataire: Casalonga, Axel

(57) **Abrégé**

Boîtier semi-conducteur optique comprenant un support présentant un passage de réception d'une bague portant une lentille située en face d'un capteur optique.

Ledit support (6) présente, dans ledit passage (6a), au moins un évidement local de dégagement (9) et la bague (7) est munie périphériquement d'un moyen élastiquement déformable (14), localement en saillie.

Ledit évidement local de dégagement et ledit moyen élastiquement déformable sont tels que, lorsque la bague occupe une position angulaire de montage, le moyen localement en saillie est engagé dans l'évidement local du support et, lorsque la bague est pivotée à partir de la position angulaire de montage précitée, le moyen localement en saillie est amené en dehors dudit évidement du support et est en compression contre la paroi dudit passage afin de maintenir la bague par rapport au support.

## Description

La présente invention concerne le domaine des boîtiers semi-conducteurs optiques.

On connaît des boîtiers semi-conducteurs optiques qui comprennent une plaque sur une face avant de laquelle sont fixés une puce de circuits intégrés reliée électriquement à cette plaque et des moyens d'encapsulation de la puce, portant une lentille de focalisation située en face du capteur optique intégré prévu sur la face avant de cette puce.

Actuellement, ces moyens d'encapsulation comprennent une bague portant la lentille et filetée extérieurement et un support qui présente un passage fileté intérieurement. La bague est accouplée au support par vissage et le réglage de la lentille par rapport au capteur optique de la puce est obtenu en réalisant plus ou moins ce vissage. Lorsque la position de réglage est atteinte, on doit ensuite fixer la bague sur le support. Ceci se fait couramment par une opération complémentaire de collage.

La présente invention a pour but de simplifier les opérations ci-dessus d'accouplement, de réglage et de fixation.

Le boîtier semi-conducteur optique objet de la présente invention comprend un support présentant un passage de réception d'une bague portant une lentille située en face d'un capteur optique.

Selon la présente invention, ledit support présente, dans ledit passage, au moins un évidement local de dégagement formé de préférence par une rainure axiale débouchant au moins à l'une de ses extrémités et la bague est munie périphériquement d'un moyen élastiquement déformable, localement en saillie.

Selon l'invention, ledit évidement local de dégagement et ledit moyen élastiquement déformable sont tels que, lorsque la bague occupe une position angulaire de montage, le moyen localement en saillie est engagé dans l'évidement local du support et, lorsque la bague est pivotée à partir de la position angulaire de montage précitée, le moyen localement en saillie est amené en dehors dudit évidement du support et est en compression contre la paroi dudit passage afin de maintenir la bague par rapport au support.

Selon une variante de l'invention, la bague présente au moins une rainure périphérique et au moins un ergot en saillie par rapport au fond de cette rainure, ledit moyen élastiquement déformable comprenant un anneau élastiquement déformable engagé dans la rainure périphérique et passant au-dessus dudit ergot pour être localement en saillie.

Selon l'invention, ledit anneau est en contact avec la paroi dudit passage dudit support.

Selon une autre variante de l'invention, la bague présente au moins une lèvre en saillie formant ledit moyen élastiquement déformable.

Selon l'invention, la paroi dudit passage présente de préférence au moins un évidement local secondaire angulairement décalé par rapport audit évidement local de dégagement, ledit moyen localement en saillie s'engageant dans cet évidement local secondaire lorsque la bague est à une position angulaire de maintien.

Selon l'invention, ledit évidement local secondaire est de préférence formé par une rainure axiale débouchant au moins à l'une de ses extrémités.

Selon une variante préférée de l'invention, la paroi dudit passage du support présente au moins trois évidements locaux de dégagement périphériquement espacés et ledit moyen élastiquement déformable comprend trois parties correspondantes localement en saillie.

La présente invention sera mieux comprise à l'étude d'un boîtier semi-conducteur optique décrit à titre d'exemple non limitatif et illustré par le dessin sur lequel :
- La figure 1 représente une coupe longitudinale d'un boîtier semi-conducteur optique selon la présente invention ;
- La figure 2 représente une coupe transversale du boîtier semi-conducteur optique de la figure 1, dans une position d'engagement ;
- La figure 3 représente une coupe transversale du boîtier semi-conducteur optique de la figure 1, dans une position de réglage et de maintien ;
- La figure 4 représente une coupe transversale d'une variante de réalisation du boîtier semi-conducteur optique précité, dans une position d'engagement ;
- La figure 5 représente une coupe transversale du boîtier semi-conducteur optique de la figure 4, dans une position de réglage et de maintien.

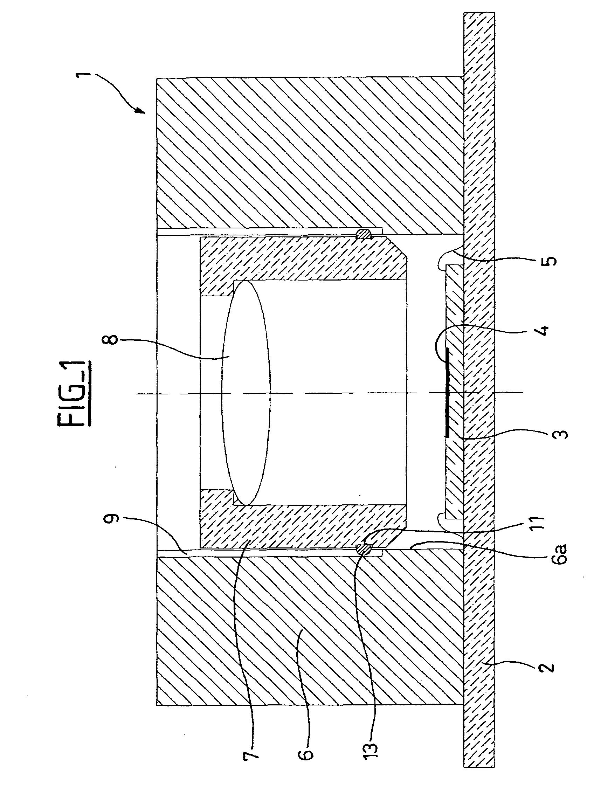

En se reportant aux figures 1 à 3, on peut voir qu'on a représenté un boîtier semi-conducteur optique 1 qui comprend une plaque de connexion électrique 2 sur une face avant de laquelle est fixée par collage la face arrière d'une puce de circuits intégrés 3, dont la face avant présente un capteur optique 4. Des plots de connexion électrique prévus sur la face avant de la puce 3 sont reliés à des plots de la face avant de la plaque 2 par de fils de connexion électrique 5.

Sur la face avant de la plaque 2 est fixé un support annulaire 6 qui entoure à distance la puce 3 et les fils 5, ce support 6 présentant un passage cylindrique 6a de réception d'une bague cylindrique 7 portant dans son passage une lentille optique 8 de focalisation, située en face du capteur optique 4 de la puce 3.

La paroi du passage cylindrique de réception 6a présente des évidements locaux de dégagement constitués par trois rainures axiales de dégagement 9 réparties périphériquement à 120°, ainsi que des évidements locaux secondaires constitués par trois rainures axiales secondaires 10 réparties périphériquement à 120° et décalées angulairement par rapport aux rainures axiales principales 9, par exemple de 30°, les rainures axiales de dégagement 9 et les rainures axiales secondaires 10 débouchant à l'extrémité avant du passage 6.

En section, les rainures axiales de dégagement 9 et les rainures axiales secondaires 10 présentent des fonds arrondis concaves et des bords arrondis convexes. La profondeur des rainures axiales de dégagement 9 est largement plus grande que la profondeur des rainures axiales secondaires 10.

La bague cylindrique 7 présente une rainure périphérique 11 au fond de laquelle sont prévus trois ergots en saillie 12 répartis à 120° n'atteignant pas les bords de cette rainure 11.

Dans la rainure périphérique 11 de la bague 7 est disposé un anneau élastiquement déformable 13 qui passe au-dessus des ergots 12 pour constituer, en trois endroits, des parties 14 localement en saillie par rapport à la face périphérique de la bague 7.

Pour accoupler la bague 7 dans le support 6, on peut procéder de la manière suivante.

Par exemple à l'aide d'un outil spécialement adapté à cet effet, on place axialement la bague 7 en face du passage 6a du support 6 en plaçant les parties 14 localement en saillie de l'anneau élastiquement déformable 13 en face des rainures axiales de dégagement 9.

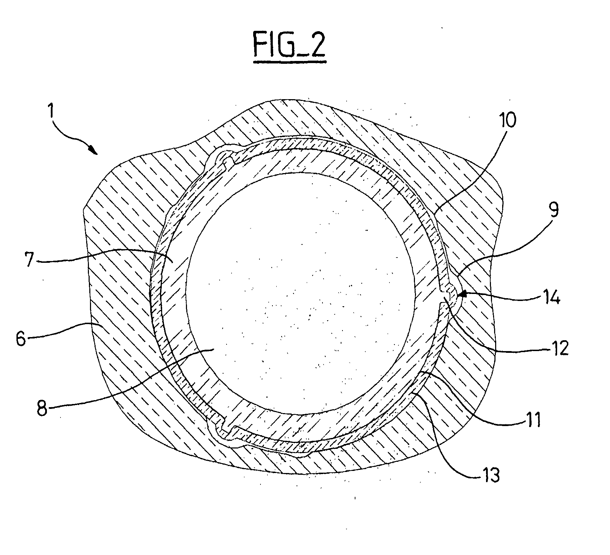

Comme le montre la figure 2, on engage axialement la bague 7 dans le passage 6a du support 6 jusqu'à une position axiale de réglage de la lentille 8 par rapport au capteur optique 4 de la puce 3.

La rainure périphérique 11 de la bague 7, ses ergots 12, l'anneau 13 et les rainures axiales de dégagement 9 du support 6 sont dimensionnés de telle sorte que ce mouvement d'engagement se fasse de préférence sans frottement.

Lorsque ladite position axiale de réglage est atteinte, on fait pivoter ou tourner la bague 7 par rapport au support 6 Ce faisant, les parties 14 localement en saillie de l'anneau 13 sont amenées en dehors des rainures axiales de dégagement 9 du support 6 et sont en compression contre la paroi du passage 6a de ce support. Le diamètre intérieur du passage 6a du support 6, le diamètre extérieur de la bague 7 et l'épaisseur des parties 14 localement en saillie de l'anneau 13 sont adaptés à cet effet.

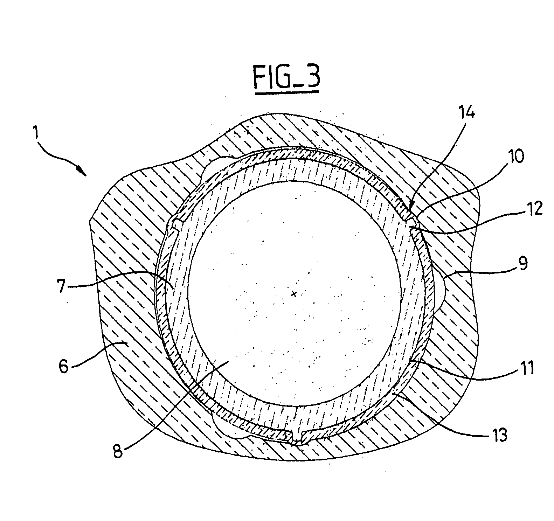

Comme le montre la figure 3, lorsque les parties 14 localement en saillie de l'anneau 13 arrivent en face des rainures secondaires 10, on arrête la rotation de la bague 7, ces parties 14 s'expansant légèrement dans ces rainures secondaires 10.

Puis, on libère la bague 7 qui alors se trouve maintenue dans sa position axiale de réglage sous l'effet de la compression élastique des parties 14 localement en saillie de l'anneau 13.

L'anneau élastique 13 peut en outre être en contact avec la paroi du passage 6a du support 6 de façon à constituer un joint de protection.

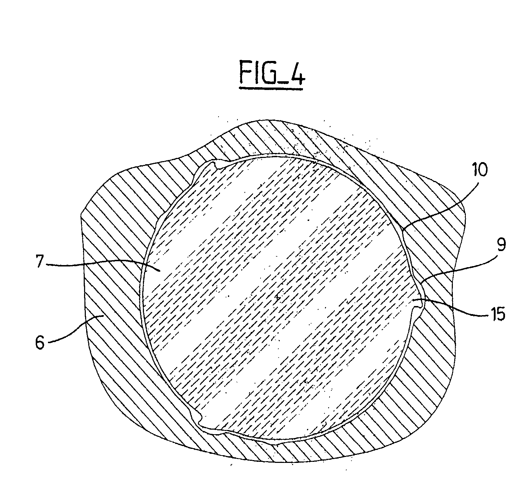

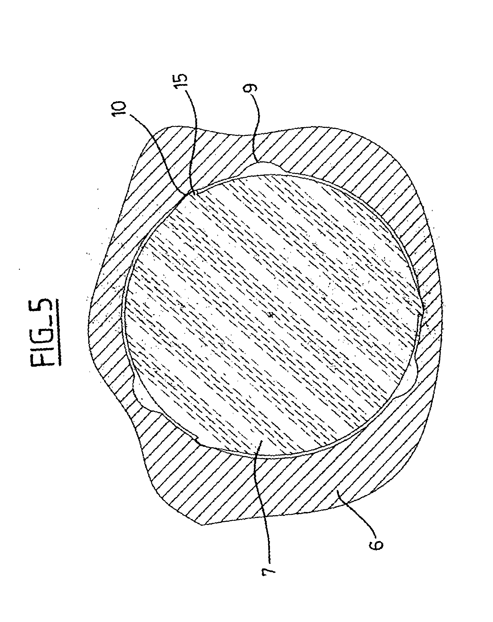

En se reportant aux figures 4 et 5, on peut voir qu'on a représenté une variante de réalisation du boîtier 1, dans laquelle le moyen de blocage de la bague 7 est, cette fois, constitué par trois lèvres en saillie 15 s'étendant longitudinalement sur au moins une partie de la longueur de la paroi extérieure de la bague 7 et réparties à 120°. Dans l'exemple représenté, les lèvres 15 sont parties intégrantes de la bague 7. Dans une variante, elles pourraient être rapportées.

Les lèvres 15 présentent une section qui va en se réduisant de leur racine à leur extrémité et sont inclinées. Le matériau choisi pour réaliser la bague 7 est tel que les lèvres 15 sont élastiquement déformables.

L'accouplement de la bague 7 munie des lèvres 15 au support 6 peut être effectué comme décrit dans l'exemple précédent, l'épaisseur des lèvres élastiquement déformables 15 étant adaptée à l'effet de compression mentionné plus haut. En outre, les lèvres 15 sont de préférence inclinées dans le sens contraire du sens de rotation de la bague 7 lors de l'accouplement.

Ainsi, comme le montre la figure 4, on engage axialement la bague 7 dans le passage 6a du support 6 en engageant les lèvres en saillie 15 axialement dans les rainures axiales de dégagement 9 de ce support 6, jusqu'à une position axiale de réglage de la lentille 8 par rapport au capteur optique 4 de la puce 3, les lèvres 13 et les rainures axiales de dégagement 9 du support 6 étant dimensionnées de telle sorte que ce mouvement d'engagement se fasse de préférence sans frottement.

Lorsque ladite position axiale de réglage est atteinte, on fait pivoter ou tourner la bague 7 par rapport au support 6 Ce faisant, les lèvres 15 de la bague 7 sont amenées en dehors des rainures axiales de dégagement 9 du support 6 et sont comprimées contre la paroi du passage 6a de ce support. Le diamètre intérieur du passage 6a du support 6, le diamètre extérieur de la bague 7 et la forme et l'épaisseur des lèvres 15 en saillie de cette bague 7 sont adaptés à cet effet.

Comme le montre la figure 5, lorsque les lèvres 15 arrivent en face des rainures secondaires 10, on arrête la rotation de la bague 7, ces parties 14 s'expansant légèrement dans ces rainures secondaires 10.

Puis, on libère la bague 7 qui alors se trouve maintenue dans sa position axiale de réglage sous l'effet de la compression élastique des lèvres 15 de la bague 7.

La présente invention ne se limite pas à l'exemple ci-dessus décrit. Bien de variantes sont possibles sans sortir du cadre défini par les revendications annexées.

## Revendications

1. Boîtier semi-conducteur optique comprenant un support présentant un passage de réception d'une bague portant une lentille située en face d'un capteur optique, **caractérisé par le fait que** ledit support (6) présente, dans ledit passage (6a), au moins un évidement local de dégagement (9) formé par une rainure axiale (9) débouchant au moins à l'une de ses extrémités et que la bague (7) est munie périphériquement d'un moyen élastiquement déformable (14), localement en saillie, ledit évidement local de dégagement et ledit moyen élastiquement déformable étant tels que, lorsque la bague occupe une position angulaire de montage, le moyen localement en saillie est engagé dans l'évidement local du support et, lorsque la bague est pivotée à partir de la position angulaire de montage précitée, le moyen localement en saillie est amené en dehors dudit évidement du support et est en compression contre la paroi dudit passage afin de maintenir la bague par rapport au support.

2. Boîtier selon la revendication 1, **caractérisé par le fait que** la bague présente au moins une rainure périphérique (11) et au moins un ergot (12) en saillie par rapport au fond de cette rainure, ledit moyen élastiquement déformable comprenant un anneau élastiquement déformable (13) engagé dans ladite rainure périphérique et passant au-dessus dudit ergot pour être localement en saillie.

3. Boîtier selon la revendication 2, **caractérisé par le fait que** ledit anneau (13) est en contact avec la paroi dudit passage dudit support.

4. Boîtier selon la revendication 1, **caractérisé par le fait que** la bague présente au moins une lèvre en saillie (15) formant ledit moyen élastiquement déformable.

5. Boîtier selon l'une quelconque des revendications précédentes, **caractérisé par le fait que** la paroi dudit passage présente au moins un évidement local secondaire (10) angulairement décalé par rapport audit évidement local de dégagement (9), ledit moyen localement en saillie (14) s'engageant dans cet évidement local secondaire lorsque la bague est à une position angulaire de maintien.

6. Boîtier selon l'une quelconque des revendications précédentes, **caractérisé par le fait que** ledit évidement local secondaire est formé par une rainure axiale (10) débouchant au moins à l'une de ses extrémités.

7. Boîtier selon l'une quelconque des revendications précédentes, **caractérisé par le fait que** la paroi dudit passage du support présente au moins trois évidements locaux de dégagement périphériquement espacés et que ledit moyen élastiquement déformable comprend trois parties correspondantes localement en saillie.
